# EUROPEAN PATENT APPLICATION

(11) **EP 2 933 482 A1**
(43) Date of publication of application: **21.10.2015**
(21) Application number: 15164223.8
(22) Date of filing: 20.04.2015
(51) Int. Cl.: F03D 11/00, F03D 1/06, H05K 9/00

(54) **ELECTROMAGNETIC SHIELDING OF A STRAIN GAUGE IN A WIND POWER INSTALLATION**

(30) Priority: 18.04.2014 IN MU14102014
(71) Applicant: Kharkar, Ashish Bhimrao, 444 601 Amravati (IN); Kulkarni, Omprakash Ganpatrao, 422 002 Nashik (IN); Mehra, Yogesh Jogindernath, 400 049 Mumbai (IN)
(72) Inventor: Kharkar, Ashish Bhimrao, 444 601 Amravati (IN); Kulkarni, Omprakash Ganpatrao, 422 002 Nashik (IN); Mehra, Yogesh Jogindernath, 400 049 Mumbai (IN)
(74) Representative: Manitz, Finsterwald & Partner GbR

(57) **Abstract**

The present subject matter relates to a wind power installation having a strain gauge (100) mounted on the wind power installation for measuring stresses on the wind power installation. The wind power installation further includes an electromagnetic shielding tape (602) wrapped around the strain gauge (100) for shielding the strain gauge (100) against at least one of static charges and lightning strikes. Further, the electromagnetic shielding tape (602) includes an electrically conductive material, a magnetically conductive material, and a self adhesive coating.

## Description

### TECHNICAL FIELD

The present subject matter is related to a wind power installation in general and, in particular, to electromagnetic shielding of a strain gauge in the wind power installation against static charges and/or lightning strikes.

### BACKGROUND

Wind power installations utilize wind energy to produce electrical power. Nowadays, the wind power installations are huge in size and include large blades. Such wind power installations are typically installed in remote locations and difficult terrain generally not easily accessible. Therefore, installation of wind power installation in such locations involves complicated logistics for organizing the movement of materials and also the skilled personnel. For the same reason, these wind power installations are generally expensive and inefficient to monitor or service on a regular basis. However, regular maintenance and repairs are essential for maximum availability of the wind power installations.

### BRIEF DESCRIPTION OF THE DRAWINGS

The detailed description is described with reference to the accompanying figures. In the figures, the left-most digit(s) of a reference number identifies the figure in which the reference number first appears. The same numbers are used throughout the drawings to reference like features and components.
Figure 1 illustrates a schematic view of a strain gauge.
Figure 2 illustrates a schematic view of a strain gauge having provision for mounting to a solid body.
Figure 3 illustrates a schematic view of a strain gauge mounting assembly.
Figure 4 illustrates a schematic view of a strain gauge mounting assembly along with an output cable.
Figure 5 illustrates a schematic view of a strain gauge protected with a common electromagnetic shield metal enclosure.
Figure 6(a) illustrates a schematic view of an electromagnetic shielding tape for protection of a strain gauge, according to an embodiment of the present subject matter.
Figure 6(b) illustrates a schematic view of an electromagnetic shielding tape being wrapped on the strain gauge, according to an embodiment of the present subject matter.
Figure 6(c) illustrates a schematic view of an electromagnetic shielding tape wrapped on the strain gauge, according to an embodiment of the present subject matter.
Figure 7 illustrates a schematic view of a rotor of a wind power installation with an electromagnetic shielding tape wrapped around a strain gauge that is mounted on the rotor, according to an embodiment of the present subject matter

### DETAILED DESCRIPTION

Wind power installations are typically subject to large stresses, such as static stresses due to their own weight and dynamic stresses due to wind and/or rotations of the blades. To measure such stresses, a sensor, such as a strain gauge, may be provided in a wind power installation at a suitable measurement point, such as tower, nacelle, or rotor of the wind power installation. The sensor is typically coupled to a load control box in the wind power installation. The load control box is configured to take, based on stresses measured by the strain gauge, corrective measures for reducing stresses on the wind power installation. Examples of such corrective measures include reducing speed of a rotor of the wind power installation.

Investigations have indicated that a lightning strike typically produces a strong electromagnetic field within a distance of 900 feet from the geometrical centre of a lightning site. The strong electromagnetic field produced by such a lightning strike on or in the vicinity of the wind power installation has detrimental effects on various sensors and systems of the wind power installation. Further, static charges are produced on blades of the wind power installation. These static charges are caused by friction against the wind flowing along the blades' surfaces. These static charges on the blades of the wind power installation contribute in producing the strong electromagnetic field.

Such a strong electromagnetic field can cause malfunctioning or failure of the strain gauge, if no electromagnetic shielding is provided to the strain gauge. The malfunctioning or the failure of strain gauge can in turn cause malfunctioning or failure of the load control box. In some cases, the malfunctioning or failure of the strain gauge and/or the load control box can cause an unwanted stoppage of the wind power installation. Such unwanted stoppage of the wind power installation not only leads to revenue losses, but also results in loss of goodwill and reputation of the manufacturer of the wind power installation. Further, such unwanted stoppage may require a manual restart for the wind power installation, which is labor intensive. Further, stresses acting on the wind power installation may not be taken care of due to the unwanted stoppage of the wind power installation,

Conventionally, a metal enclosure may be provided to electromagnetically shield the strain gauge. However, the installation and regular maintenance of the metal enclosure installation are difficult and cumbersome tasks which are to be performed by skilled personnel. More specifically, the metal enclosure is heavy and occupies substantial space. Moreover, installation of the metal enclosure requires hardware components, such as nuts, bolts, and mounting brackets, and tools. The installation of the metal enclosure may affect nearby instruments. For example, the installation of the metal enclosure may affect calibration and reliability of the strain gauge. Further, the metal enclosure may cause accidents in case of loose connections or loose mounting. Further, the metal enclosure is susceptible to dislocation due to vibrations during the operation of the wind power installation.

On this note, the present subject matter describes electromagnetic shielding of a strain gauge using an electromagnetic shielding tape that can be wrapped around the strain gauge. The electromagnetic shielding tape shields the strain gauge from the strong electromagnetic field produced because of static changes and/or lightning strikes. The electromagnetic shielding tape comprises an electrically conductive material, such as Copper, and a magnetic conductive material, such as Nickel. The electromagnetic shielding tape further comprises a self adhesive coating for easy fixing of the electromagnetic shielding tape on the strain gauge.

The electromagnetic shielding tape is not only light weight and economical as compared to the conventionally provided metal enclosure, but also is easy to fix and does not occupy extra space. Further, fixing of the electromagnetic shielding tape does not require any hardware or tools for its installation or maintenance. The fixing of the electromagnetic shielding tape, therefore, does not require special skills and can be performed at the site of the strain gauge without removing the rotor blades or bringing down the strain gauge on the ground from an existing wind power installation, unlike as required for installing the conventionally provided metal enclosure. Also, the fixing is easy, quick, and risk free for field staff even when done for the existing wind power installation.

Further, wrapping of the electromagnetic shielding tape on the strain gauge has no effect on the reliability and calibration of the strain gauge. The electromagnetic shielding tape prevents strain gauge from physical damage and sending undesired error signals. Further, the electromagnetic shielding tape facilitates in preventing the unwanted stoppages of the wind power installation due to damage or malfunctioning of the strain gauge, and consequent losses of revenue and goodwill for a manufacturer of the wind power installation.

Furthermore, the electromagnetic shielding tape is cost effective as it does not deteriorate with time as compared to the conventionally provided metal enclosure. Further, the electromagnetic shielding tape can withstand all adverse climatic and physical conditions, i.e., high relative humidity, saline conditions, extreme high and low temperatures, dusty conditions, vibrations, jerks, flexible material, etc. Since the electromagnetic shielding tape is made of fine wires from Copper and Nickel, which is woven like a fabric cloth and is flexible, the electromagnetic shielding tape can be wrapped in any desired shape.

Further aspects of the present subject matter are apparent from the examples of embodiment to be described hereinafter and are explained with reference to the examples of embodiment. Although the further aspects of the present subject matter are explained in comparison with the conventionally provided metal enclosure, the advantages of wrapping the electromagnetic shielding tape around the strain gauge are general over other known techniques of shielding. The present subject matter will be described in more detail hereinafter with reference to examples of embodiment, but to which the present subject matter is not limited.

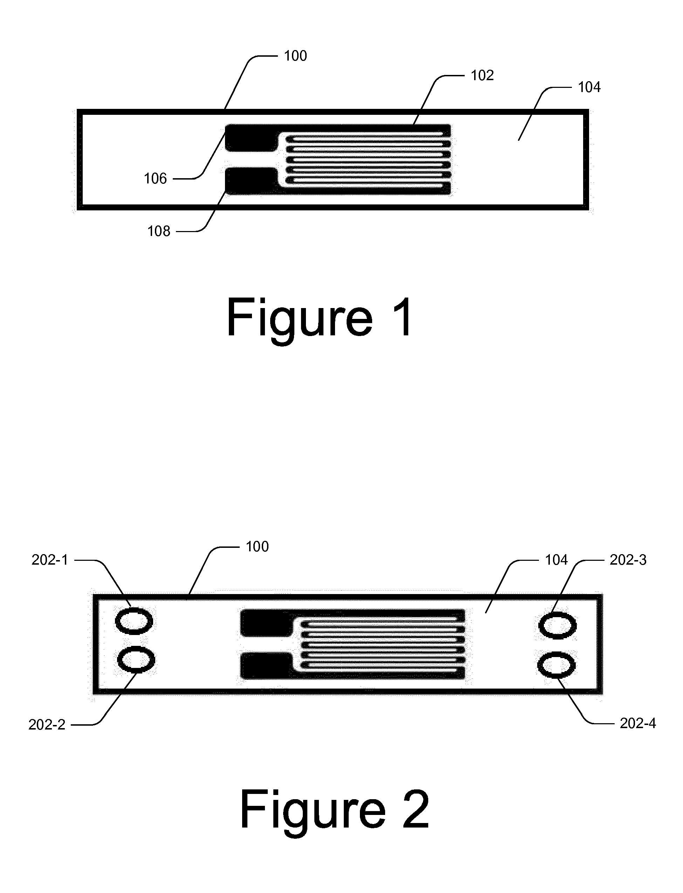

Figure 1 illustrates a schematic view of a strain gauge 100 that may be used for measuring stresses in the wind power installation. The strain gauge 100 comprises a metallic film that is provided in the form of a strip 102. The strip 102 can be deposited on a nonconducting substrate referred to as a carrier 104. The strip 102 is in the form of in a zigzag pattern of parallel conductive lines of Eureka Alloy or any other suitable alloy or metal. Even a small amount of stress in the direction of orientation of the parallel lines results in substantial change in end-to-end resistance of the strip 102, than would be observed with a single straight conductive line. Accordingly, the strip, 102 when placed under a stretching force becomes skinnier and longer. Both these changes resulting in an increase of the end-to-end electrical resistance which is dependent on the dimensions of the strip 102. Conversely, when the strip 102 is placed under a compressive force, without buckling, the strip becomes broader and shorter.

To ensure that the strip 102 does not break or permanently deform, the strip 102 may be designed such that the elastic limit of the strip 102 encompasses magnitude of stresses exerted on the strip 102. The change in the end-to-end electrical resistance may be measured by connecting the end points 106 and 108 of the strip 102 with a bridge circuit (not shown), such as a Wheatstone bridge circuit. The bridge circuit allows for precise measurement of the small resistance changes and nullifies effect of ambient temperature.

Figure 2 illustrates a schematic view of the strain gauge 100 having a provision for mounting the it on a solid body, such as a wind power installation. For this purpose, the strain gauge 100 includes a plurality of holes 202-1, 202-2, 202-3, & 202-4, hereinafter collectively referred to as the holes 202. The holes 202 may be provided in the region of the carrier 104 of the strain gauge 100, as shown. The strain gauge 100 may be mounted on the wind power installation using a nut and bolt coupling through the holes 202.

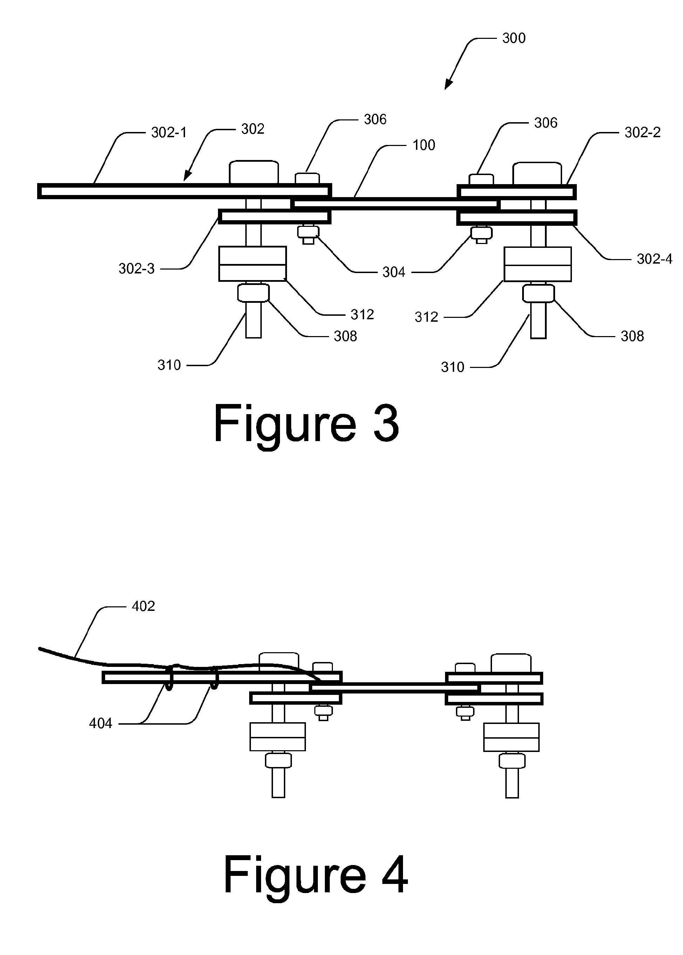

Figure 3 illustrates a schematic view of a strain gauge mounting assembly 300, hereinafter referred to as the assembly 300. The assembly 300 may be mounted on the wind power installation at a suitable measurement point, such as on top or at base region of the tower or the nacelle or the rotor of the wind power installation. The assembly 300 includes the strain gauge 100 and a metal clamp 302 to clamp the strain gauge 100. The metal clamp 302 may include a plurality of clamping components 302-1, 302-2, 302-3, & 302-4, as shown. In one embodiment, one clamping component 302-1 may be longer than the other clamping components 302-2, 302-3, & 302-4 to allow for easy handling of the assembly 300 of the metal clamp 302 and strain gauge 100. In this way, a user may hold the assembly 300 using the longer clamping component 302-1.

The strain gauge 100 may be clamped in the metal clamp 302 through nuts 304 and bolts 306 as shown in the Figure 3. The assembly 300 of the strain gauge 100 and metal claim 302 may be mounted on to the wind power installation through nuts 308 and bolts 310. The bolts 310 may be provided with a supporting flange 312 to a keep a suitable distance between the strain gauge 100 and the wind power installation allowing free span to the strain gauge 100 for sensing elongation or compression in the mounting surface.

Figure 4 illustrates a schematic view of a strain gauge 100 mounting assembly along with an output cable 402. A first end of the output cable 402 may be connected with the strain gauge 100, whereas a second end of the output cable may be connected with the above mentioned load control box (not shown). In one embodiment, the longer clamp component 302-1 may be provided with a provision, such one or more holes 404, through which the second end of the output cable 402 may be directed to the bridge circuit or the load control box. In one implementation, the output cable 402 may be tied to the longer claim component 302-1 using zip ties, which may tie the output cable 402 with the longer clamp component 302-1 utilizing the one or more holes 404.

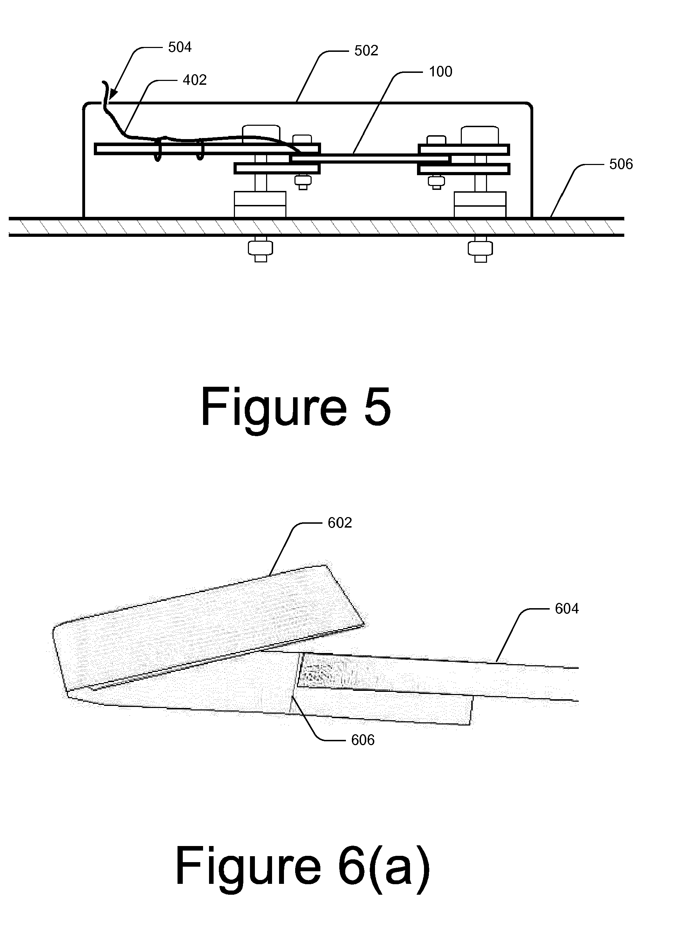

Figure 5 illustrates a schematic view of a strain gauge 100 electromagnetic shielded using a conventional metal enclosure 502. The conventional metal enclosure 502 has at least one hole 504 through which the output cable 402 of the strain gauge 100 can be taken out for connection with the bridge circuit or the load control box. The conventional metal enclosure 502 is fixed to a wall 506 of a desired part, such as a rotor, a tower, and a nacelle, of the wind power installation. The fixing may be done by in a variety of ways known in the art.

Figure 6(a) illustrates a schematic view of an electromagnetic shielding tape 602 which is used for shielding the strain gauge 100 against electrostatic charges and lightning strikes, according to an embodiment of the present subject matter. The shielding is the practice of reducing electromagnetic fields in a space by blocking the electromagnetic fields with barriers made of conductive and/or magnetic materials. The electromagnetic shielding tape 602 is made from flexible materials for wrapping around the strain gauge 100. More particularly, the electromagnetic shielding tape 602 includes an electrically conductive material, a magnetically conductive material, and a self adhesive coating. In comparison to the conventionally provided metal enclosure, the electromagnetic shielding tape provides better shielding to the strain gauge against static charges developed on the rotor blades of the wind power installation and lightning strikes in the vicinity of or on the wind power installation.

In one embodiment, the electromagnetic shielding tape 602 is in form of a fabric made of the electrically conductive material and the magnetically conductive material woven, press rolled, or bonded together. The electromagnetic shielding tape 602, on one side, may be provided with a self adhesive coating that helps to wrap the electromagnetic shielding tape 602 on the strain gauge 100 such that the electromagnetic shielding tape 602 is not dislocated while the wind power installation is operational. The self adhesive coating may be of an electrically conductive sticky material or glue of some chemical compound to extend electrical connection with Copper Nickel fabric and Strain gauge mounting strip which is grounded. The self adhesive coating avoids the requirement of extra hardware components and tools as required for installing the conventional metal enclosure 502. In addition, fixing the electromagnetic shielding tape 602 on the strain gauge 100 is easier, quicker, economical, and risk free. The electromagnetic shielding tape 602 consumes less space and is durable as compared to the electromagnetic shield metal enclosure 502.

In one embodiment, the electrically conductive material may be Copper (Cu). In one embodiment, the magnetically conductive material may be Nickel (Ni). It has been found that combination of Copper and Nickel provides substantial protection of the strain gauge 100 as it has high electromagnetic shielding effectiveness. Further, the combination of Copper and Nickel can operate in an operating temperature range of about -25°C to +80°C or even a broader temperature range. Here, the operating temperature range is a temperature range in which the strain gauge can operate. In said embodiment, the electromagnetic shielding tape 602 may be formed with a surface resistance of about 0.11Ω/cm² and a volume resistance of about 0.03Ω/cm³. The surface resistance and the volume resistance is measured on outer side, i.e., non-adhesive side of the electromagnetic shielding tape 602. The electromagnetic shielding tape 602 having the above mentioned surface and volume resistances with reasonable tolerance limits provides substantial shielding of strain gauge 100 in a wind power installation against strong electromagnetic field produced due to static charges, lightning strikes, and any other unwanted electromagnetic interference.

In one embodiment, a flexible base material with a thin Copper wire as the electrically conductive material and a thin Nickel wire as the magnetic conductive material may be used to form the electromagnetic shielding tape 602. In this embodiment, the electromagnetic shielding tape 602 may be provided with a self adhesive coating on one side of the electromagnetic shielding tape 602.

In one embodiment, any electrical conductor material coated with any magnetic material may be used to form the electromagnetic shielding tape 602. Alternatively, any magnetic material coated with any electrical conductor material may also be used to form the electromagnetic shielding tape 602. The coating may be done using methods known in the art, such hot dipping, chemical deposition, ionic deposition, or electroplating deposition. Further, the electromagnetic shielding tape 602 may be provided with or without a protective coating as per design requirements. The protective coating may be in form of be an electrically insulating tape of Mylar, Polyester, or the like. The purpose of the protective coating is to further hold the Copper Nickel fabric in place in addition to its adhesive and to protect it from dust, moisture, and other climatic adverse effects.

In one embodiment, the electromagnetic shielding tape 602 may be produced in form of a bundle having a substantial amount of the electromagnetic shielding tape 602. The length of the electromagnetic shielding tape 602 required from the bundle for wrapping the strain gauge 100 may be marked using a length scaling apparatus 604. A mark 606 may be provided on the electromagnetic shielding tape 602 for cutting the required length of the electromagnetic shielding tape 602 from the bundle. The mark 606 may be provided manually or automatically in the factory at the time of production of the tape 602 in the form of a bundle.

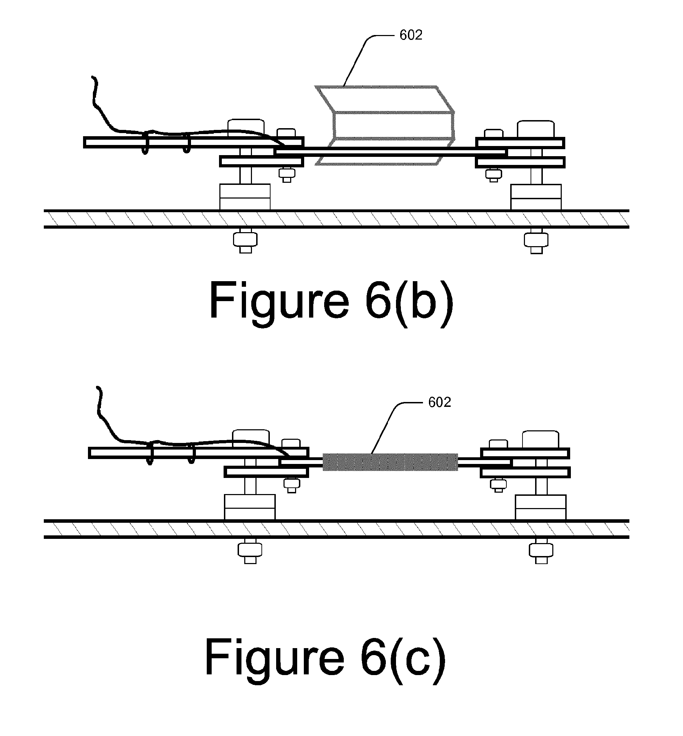

Figure 6(b) illustrates a schematic view of the electromagnetic shielding tape 602 being wrapped on the strain gauge 100, according to an embodiment of the present subject matter. The electromagnetic shielding tape 602 may be manually wrapped on the strain gauge 100 before making the assembly 300 of the strain gauge 100 and the metal clamp 302. Alternatively, the electromagnetic shielding tape 602 may be wrapped on the strain gauge 100 after making the assembly 300 of the strain gauge 100 and the metal clamp 302.

In case of an existing wind power installation, the electromagnetic shielding tape 602 may be wrapped on the strain gauge 100 at the site of the strain gauge 100 in the wind power installation. For example, if the strain gauge 100 is mounted on the rotor of the wind power installation, then maintenance staff may take the electromagnetic shielding tape 602 to the location of the strain gauge 100 and wrap it on the strain gauge 100 without requiring bringing down the rotor or the strain gauge 100 on the ground or removal of the blades from the wind power installation. In this way, the calibration and reliability of the strain gauge 100 remains unaffected, unlike the case while installing the electromagnetic shield metal enclosure 502.

In one embodiment, an electrically conductive heat sink compound may be provided underneath the metal clamp 302 to make electrical connectivity between the metal clamp 302 and the electromagnetic shielding tape 602.

Figure 6(c) illustrates a schematic view of the electromagnetic shielding tape 602 wrapped on the strain gauge 100, according to an embodiment of the present subject matter. Once the strain gauge 100 is fully wrapped under the electromagnetic shielding tape 602, only the electromagnetic shielding tape 602 may be visible by fully covering the strain gauge 100. In this way, the strain gauge 100 remains unexposed to the electromagnetic field produced due to the static charges and/or lightning strikes. Consequently, the strain gauge 100 remains unaffected from the electromagnetic field produced due to the static charges and/or lightning strikes. Moreover, aftereffects, such as stoppage of wind power installation, and loss of revenue and reputation for the manufacturer of the wind power installation are also avoided.

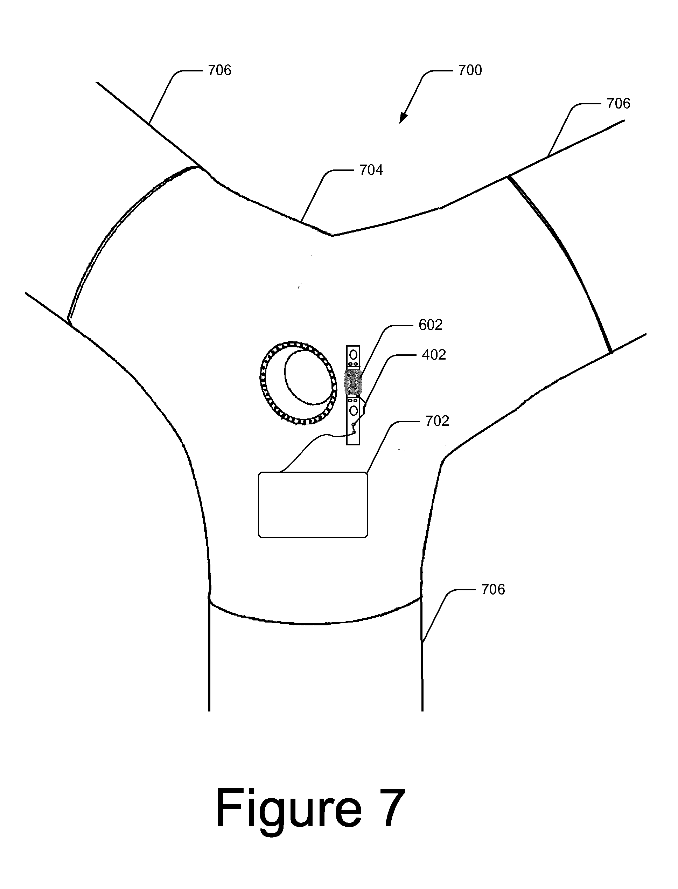

Figure 7 illustrates another schematic view of the electromagnetic shielding tape 602 wrapped on the strain gauge 100, which is mounted on a rotor 700 of the wind power installation, according to an embodiment of the present subject matter. The strain gauge 100 is mounted on the rotor 700 of the wind power installation to measure stresses on the rotor 700. The rotor 700 comprises a rotor hub 704 and rotor blades 706. The strain gauge 100 may be connected to a load control box 702 through the output cable 402. In one implementation, the strain gauge 100 and/or the load control box 702 may be mounted on a rotor hub 704 of the rotor 700 of the wind power installation. More particularly, the strain gauge 100 may be mounted on an outer or inner surface of the rotor hub 704.

The different embodiments provided above are not limiting and are only illustrative examples of the different scope of the present subject matter. Other embodiments apparent to a person skilled in the art are also included within the scope of the present subject matter.

## Claims

1. A wind power installation comprising:
a strain gauge (100) mounted on the wind power installation for measuring stresses on the wind power installation; and
an electromagnetic shielding tape (602) wrapped around the strain gauge (100) for shielding the strain gauge (100) against at least one of static charges and lightning strikes, wherein the electromagnetic shielding tape (602) comprises an electrically conductive material, a magnetically conductive material, and a self adhesive coating.

2. The wind power installation as claimed in claim 1 comprises:
a load control box (702) coupled to the strain gauge (100) to control the wind power installation based on the stresses measured by the strain gauge (100), wherein the load control box (702) controls speed of a rotor (700) of the wind power installation based on the stresses measured.

3. The wind power installation as claimed in claim 1, wherein the electrically conductive material is Copper.

4. The wind power installation as claimed in claim 1, wherein the magnetically conductive material is Nickel.

5. The wind power installation as claimed in claim 1, wherein the electromagnetic shielding tape (602) has a surface resistance of about 0.11 Ω/cm².

6. The wind power installation as claimed in claim 1, wherein the electromagnetic shielding tape (602) has a volume resistance of about 0.03 Ω/cm³.

7. The wind power installation as claimed in claim 1, wherein the electromagnetic shielding tape (602) has an operating temperature range of about -25°C to +80°C.

8. The wind power installation as claimed in claim 1, wherein the electromagnetic shielding tape (602) includes a protective coating.

9. The wind power installation as claimed in claim 1, wherein the strain gauge (100) is mounted on a rotor (700) of the wind power installation.

10. The wind power installation as claimed in claim 9, wherein the strain gauge (100) is mounted on a surface of a rotor hub (704) of the rotor (700).
